# EUROPEAN PATENT APPLICATION

(11) **EP 4 564 022 A1**
(43) Date of publication of application: **04.06.2025**
(21) Application number: 24216219.6
(22) Date of filing: 28.11.2024
(51) Int. Cl.: G01R 29/08

(54) **ANTENNA TESTING DEVICE AND ANTENNA TESTING SYSTEM**

(30) Priority: 29.11.2023 CN 202311626260
(71) Applicant: Chiun Mai Communication Systems, Inc., New Taipei City 236 (TW); Shenzhen Futaihong Precision Industry Co., Ltd., ShenZhen, Guangdong 518109 (CN)
(72) Inventor: CHANG, LUNG-TA, 236 New Taipei (TW); KAO, PING-CHI, 236 New Taipei (TW); CHEN, CHIA-HSIEN, 236 New Taipei (TW); SU, CHIA-HUNG, 236 New Taipei (TW); HUANG, CHANG-CHING, 236 New Taipei (TW); JHANG, SHU-WEI, 236 New Taipei (TW)
(74) Representative: Zaboliene, Reda

(57) **Abstract**

An antenna testing device and system for testing an antenna array are provided, the antenna testing device includes a first dielectric substrate, a plurality of radiating units, a plurality of second dielectric substrates, and a plurality of power dividers. The first dielectric substrate includes a first area and a second area surrounding the first area. The radiating units are arranged in an array in a predetermined arrangement in the first area and the second area, which is corresponding to an arrangement of a plurality of antenna radiating units of the antenna array. The power dividers are arranged among the second dielectric substrates and connected to the radiating units arranged in the first area.

## Description

### CROSS-REFERENCE TO RELATED APPLICATIONS

This application claims priority to Chinese Patent Application No. 202311626260.5 filed on November 29, 2023, in China National Intellectual Property Administration, the contents of which are incorporated by reference herein.

### FIELD

The subject matter herein generally relates to antenna technology field, and more particularly to an antenna testing device and an antenna testing system.

### BACKGROUND

In the related art, a near-field one-to-one antenna is usually used to test and calibrate an antenna under test. However, this method has a problem of low efficiency, especially in large phased antenna arrays, where its test calibration speed is severely limited. For example, when the phased antenna array has 1024 radiating elements, the antenna needs to be tested and calibrated 1024 times for each transmitting and receiving, and the displacement of the antenna must be accurately moved. This obviously greatly affects the test calibration speed of the antenna array.

### SUMMARY OF THE INVENTION

The application provides an antenna testing device and an antenna testing system to improve a testing calibration speed of the antenna array.

An antenna testing device provided by the present application configured to test an antenna array, the antenna testing device includes a first dielectric substrate, a surface of the first dielectric substrate including a first area and a second area, the second area surrounding the first area; a plurality of radiating units arranged in an array in a predetermined arrangement in the first area and the second area, the predetermined arrangement of the plurality of radiating units corresponding to an arrangement of a plurality of antenna radiating units of the antenna array; a plurality of second dielectric substrates stacked on another surface of the first dielectric substrate away from the plurality of the radiating units; and a plurality of power dividers arranged among the plurality of second dielectric substrates, the plurality of power dividers are connected to the plurality of radiating units arranged in the first area.

Further, a part of the plurality of radiating units are located in the first area, and another part of the plurality of radiating units are located in the second area, the plurality of radiating units located in the first area are configured to transmit signals or receive signals, and a part of the plurality of radiating units located in the second area are grounded.

Further, the plurality of radiating units include loop antennas.

Further, the predetermined arrangement includes each radiating unit of the plurality of radiating units is staggered between two radiating units in another row and in a triangular arrangement.

Further, the plurality of radiating units located in the second area are grounded through loads, the loads are arranged among the plurality of second dielectric substrates.

Further, each of the loads is a resistor with a resistance of 50 ohms.

Further, the plurality of power dividers are connected in sequence to form a cascade circuit structure to feed signals with a same energy to each of the plurality of detecting radiating unit arranged in the first area.

Further, the plurality of radiating units include loop antennas, the first dielectric substrate is provided with a plurality of ground through holes, each of the loop antennas is surrounded by a corresponding ground through hole, the plurality of ground through holes pass through the first dielectric substrate and the plurality of second dielectric substrates to be connected to a ground to form a clearance area, the loop antennas are arranged in the clearance area.

Further, each of the plurality of power dividers includes a first port and two second ports, each of the plurality of power dividers is configured to divide a signal received through the first port into two signals with a same energy and respectively output the two feed signals through the two second ports; or each of the plurality of power dividers is configured to combine two signals respectively received through the two second ports into one signal and output the signal through the first port.

The present invention further discloses an antenna testing system configured to test an antenna array, the antenna testing system includes the antenna testing device.

Further, the antenna testing system further includes a network analyzer, the network analyzer includes a RF output port and a RF input port, the RF output port is connected to the plurality of power dividers, the RF input port is connected to a signal port of the antenna array; or the RF output port is connected to the signal port of the antenna array, the RF input port is connected to the plurality of power dividers.

Further, the plurality of antenna radiating units of the antenna array are arranged in a square, the plurality of radiating units located in the first area are also arranged in the square; or the plurality of antenna radiating units of the antenna array are arranged in a diamond, the plurality of radiating units located in the first area are also arranged in the diamond; or the plurality of antenna radiating units of the antenna array are arranged in an octagon, the plurality of radiating units located in the first area are also arranged in the octagon.

The antenna testing device provided by the present application includes the first dielectric substrate, the plurality of radiating units, the plurality of second dielectric substrates and the plurality of power dividers. The surface of the first dielectric substrate includes the first area and the second area, the second area surrounds the first area. The plurality of radiating units are arranged in the array in the first area and the second area in the preset arrangement. In this way, the environments of the radiation units disposed in the first area are the same. In addition, the plurality of power dividers are connected to the radiation units disposed in the first area to provide feed signals. In this way, the signal strength and signal phase of the signals excited by the radiation units arranged in the first area have high consistency, meeting the design requirements of the multi-test antenna device, and can test and calibrate multiple antennas on the antenna array at the same time, thereby improving the test correction efficiency. Furthermore, the plurality of second dielectric substrates are stacked on a side of the first dielectric substrate away from the plurality of radiation units, and the plurality of power dividers are arranged between the plurality of second dielectric substrates, so that the area of the test antenna device can be reduced.

### BRIEF DESCRIPTION OF THE DRAWINGS

Implementations of the present disclosure will now be described, by way of embodiments, with reference to the attached figures.
FIG. 1 is a schematic diagram of an antenna testing system according to an embodiment of the present application when testing and calibrating an antenna array.
FIG. 2 is a schematic structural diagram of an antenna testing device according to an embodiment of the present application, presented in a XZ plane.
FIG. 3 is a schematic diagram of a first dielectric substrate in the antenna testing device shown in FIG. 2 presented in the XY plane.
FIG. 4 is a schematic diagram of one of a plurality of radiating units in the embodiment of FIG. 3.
FIG. 5A is a schematic diagram of the radiating unit provided by another embodiment of the present application.
FIG. 5B is a schematic diagram of the radiating unit provided by another embodiment of the present application.
FIG. 6 is a schematic diagram of a plurality of power dividers connected to radiating units located in a first area among the plurality of radiating units provided by an embodiment of the present application.
FIG. 7 is a schematic diagram of a plurality of power dividers connected to radiating units located in a first area among the plurality of radiating units provided by another embodiment of the present application.
FIG. 8 is a schematic diagram of a cascade circuit structure formed by connecting the plurality of power dividers in an embodiment of the present application.
FIG. 9 is a schematic diagram of the antenna testing device including six detecting radiating units and two ground radiating units in an embodiment of the present application.
FIG. 10 is a schematic diagram of the power amplitude of S-parameters measured by the six detecting radiating units shown in FIG. 9.
FIG. 11 is a phase diagram of S-parameters measured by the six detecting radiating units shown in FIG. 9.
FIG. 12 is a schematic diagram of the antenna testing device including six detecting radiating units in an embodiment of the present application.
FIG. 13 is a schematic diagram of the power amplitude of S-parameters measured by the six detecting radiating units shown in FIG. 12.
FIG. 14 is a phase diagram of S-parameters measured by the six detecting radiating units shown in FIG. 12.
FIG. 15 is a schematic diagram of a third detecting radiating unit in FIG. 9 when testing and calibrating one of the antennas on the antenna array.
FIG. 16 is a graph diagram of transmission coefficient between the detecting radiating unit in FIG. 15 and the antennas RT1 to RT6 of the antenna array.
FIG. 17 is a schematic diagram of isolation curves between a seventh detecting radiating unit and the other six adjacent detecting radiating units in FIG. 3.
FIG. 18 is a schematic diagram of a patch antenna provided by an embodiment of the present application.
FIG. 19 is a schematic diagram of a slot antenna provided by an embodiment of the present application.
FIG. 20 is a schematic diagram of isolation curves between a central loop antenna and other loop antennas among seven loop antennas.
FIG. 21 is a schematic diagram of isolation curves between a central patch antenna and other patch antennas among seven patch antennas.
FIG. 22 is a schematic diagram of isolation curves between a central slot antenna and other slot antennas among seven slot antennas.
FIG. 23 is a first arrangement diagram of the plurality of radiating units and corresponding antenna arrays provided by an embodiment of the present application.
FIG. 24 is a second arrangement diagram of the plurality of radiating units and corresponding antenna arrays provided by an embodiment of the present application.
FIG. 25 is a third arrangement diagram of the plurality of radiating units and corresponding antenna arrays provided by an embodiment of the present application.

### DETAILED DESCRIPTION

It will be appreciated that for simplicity and clarity of illustration, where appropriate, reference numerals have been repeated among the different figures to indicate corresponding or analogous elements. Additionally, numerous specific details are set forth in order to provide a thorough understanding of the embodiments described herein. However, it will be understood by those of ordinary skill in the art that the embodiments described herein can be practiced without these specific details. In other instances, methods, procedures and components have not been described in detail so as not to obscure the related relevant feature being described. The drawings are not necessarily to scale and the proportions of certain parts may be exaggerated to better illustrate details and features. The description is not to be considered as limiting the scope of the embodiments described herein.

Several definitions that apply throughout this disclosure will now be presented.

The term "coupled" is defined as connected, whether directly or indirectly through intervening components, and is not necessarily limited to physical connections. The connection can be such that the objects are permanently connected or releasably connected. The term "substantially" is defined to be essentially conforming to the particular dimension, shape, or another word that "substantially" modifies, such that the component need not be exact. For example, "substantially cylindrical" means that the object resembles a cylinder, but can have one or more deviations from a true cylinder. The term "comprising" means "including, but not necessarily limited to"; it specifically indicates open-ended inclusion or membership in a so-described combination, group, series, and the like.

In the related art, a near-field one-to-one antenna is usually used to test and calibrate an antenna under test. However, this method has a problem of low efficiency, especially in large phased antenna arrays, where its test calibration speed is severely limited. For example, when the phased antenna array has 1024 radiating elements, the antenna needs to be tested and calibrated 1024 times for each transmitting and receiving, and the displacement of the antenna must be accurately moved. This obviously greatly affects the test calibration speed of the antenna array.

Based on this, the present application provides an antenna testing device for testing an antenna array, which can improve a test calibration speed of the antenna array.

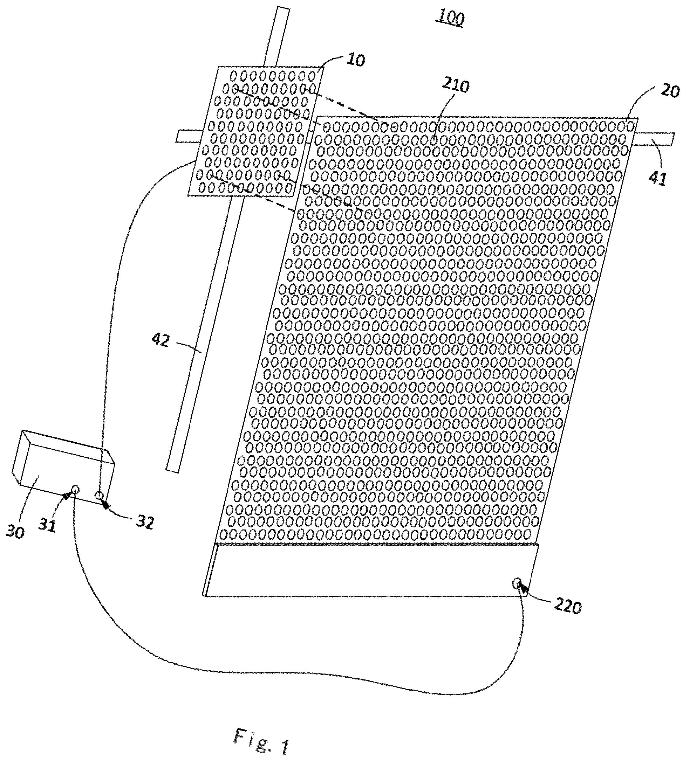

Referring to FIG. 1, the present application provides an antenna testing system 100, including an antenna testing device 10 and a network analyzer 30. The antenna testing device 10 is used to receive signals radiated by an antenna array 20 to be tested, or to radiate signals to the antenna array 20 to be tested. The network analyzer 30 is used to obtain test data generated by the antenna testing device 10 or the antenna array 20 for analysis, thereby testing and calibrating the antenna array 20.

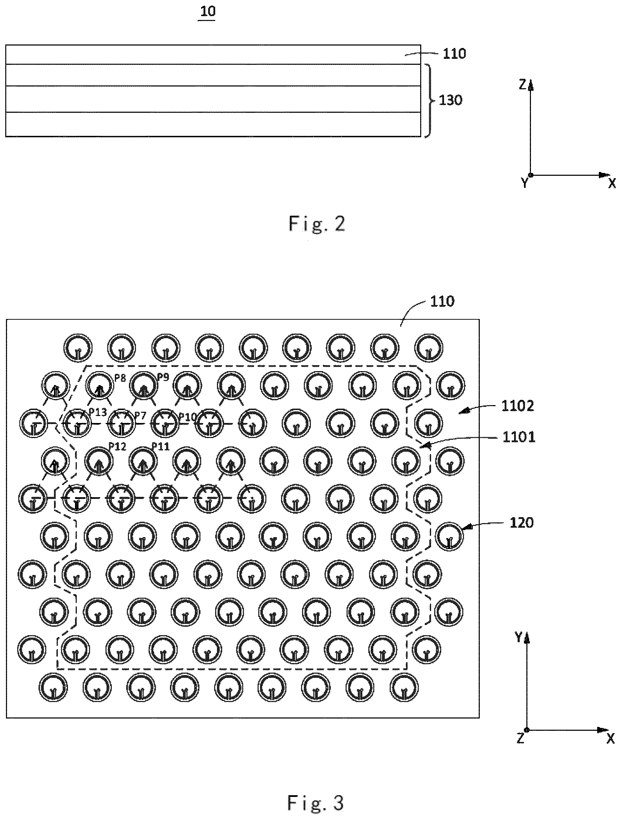

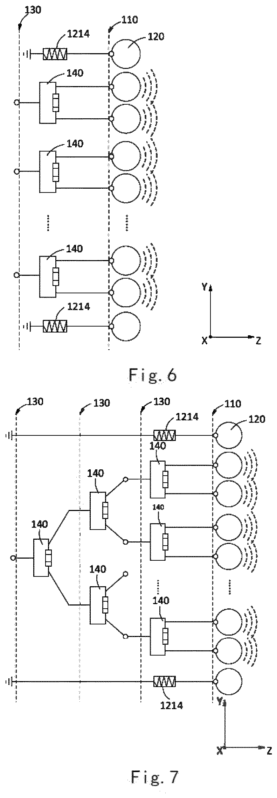

Referring to FIGS. 2 to 5, the antenna testing device 10 includes a first dielectric substrate 110, a plurality of radiating units 120 arranged in an array (see FIG. 3), a plurality of second dielectric substrates 130, and a plurality of power dividers 140 (see FIGS. 6 and 7).

Referring to FIGS. 2 and 3, the plurality of radiating units 120 are arranged on a surface of the first dielectric substrate 110. Referring to FIGS. 2, 6, and 7, the plurality of power dividers 140 are arranged among the plurality of second dielectric substrates 130.

Referring to FIG. 3, a surface of the first dielectric substrate 110 includes a first area 1101 and a second area 1102, and the second area 1102 surrounds the first area 1101. Specifically, in the embodiment, the second area 1102 is located approximately in an edge area of the first dielectric substrate 110, and the first area 1101 is located in an area inside the second area 1102. That is to say, the second area 1102 is located around the first area 1101 and surrounds the first area 1101.

The plurality of radiating units 120 are arranged in an array in a predetermined arrangement in the first area 1101 and the second area 1102. That is to say, the plurality of radiating units 120 are arranged in an array on one surface of the first dielectric substrate 110 in a predetermined arrangement, and a part of the plurality of radiating units 120 are located in the first area 1101, and another part of the plurality of radiating units 120 are located in the second area 1102. The plurality of radiating units 120 located in the first area 1101 and the plurality of radiating units 120 located in the second area 1102 are the same radiating units with the difference is that the plurality of radiating units 120 (hereinafter referred to as detecting radiating units) located in the first area 1101 are used to transmit signals or receive signals, and at least a part of the plurality of radiating units 120 (hereinafter referred to as grounded radiating units) located in the second area 1102 are grounded. In this way, by disposing the grounded radiating units around the detecting radiating units, each detecting radiating unit among the plurality of radiating units 120 can have adjacent radiating units (i.e., each detecting radiating unit has adjacent radiating units and/or grounded radiating units). That is to say, through such a design, the radiating units disposed at the edge of the first area 1101 among the plurality of radiating units 120 are also surrounded by grounded radiating units, so that an environment of the radiating units disposed at the center of the first area 1101 among the plurality of radiating units 120 is the same as that of the radiating units disposed at the edge of the first area 1101, which ultimately results in a high consistency in an amplitude and phase of the signal output by each detecting radiating unit.

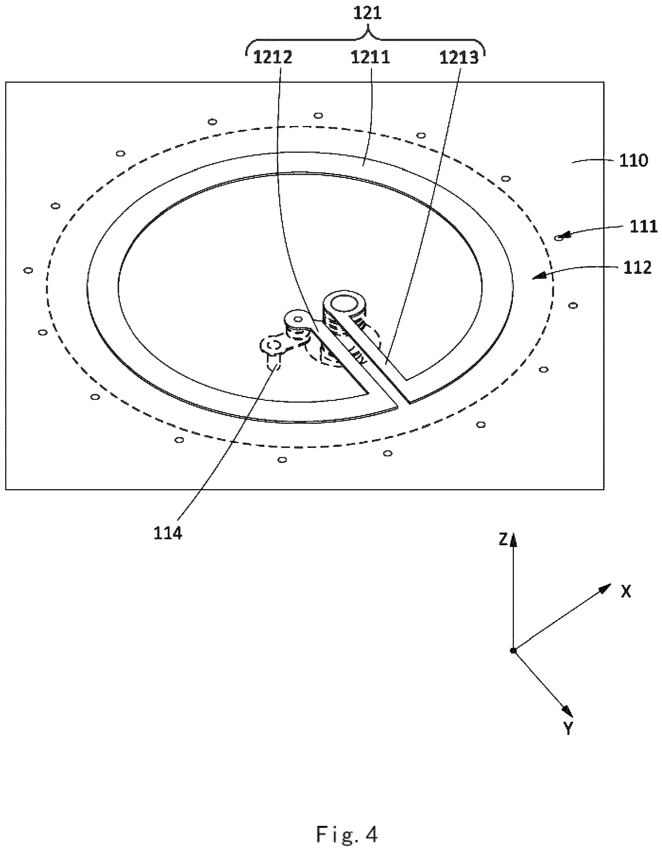

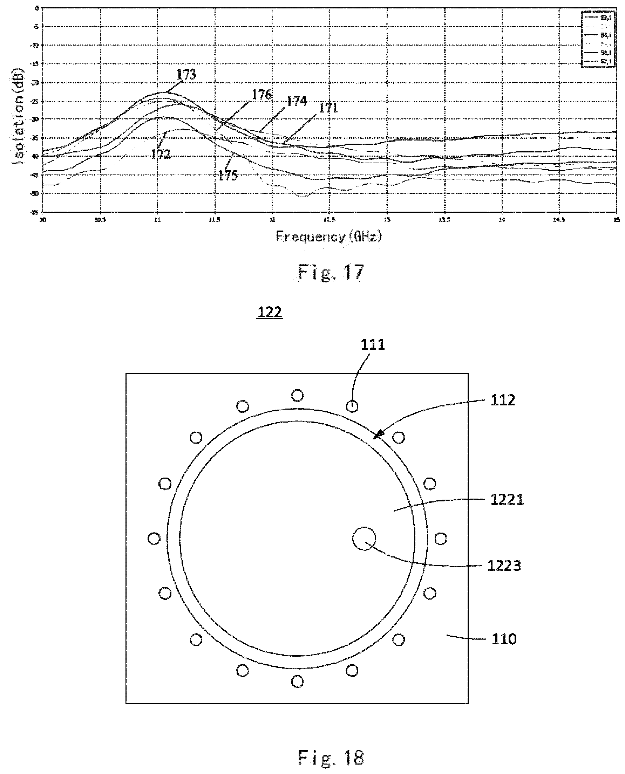

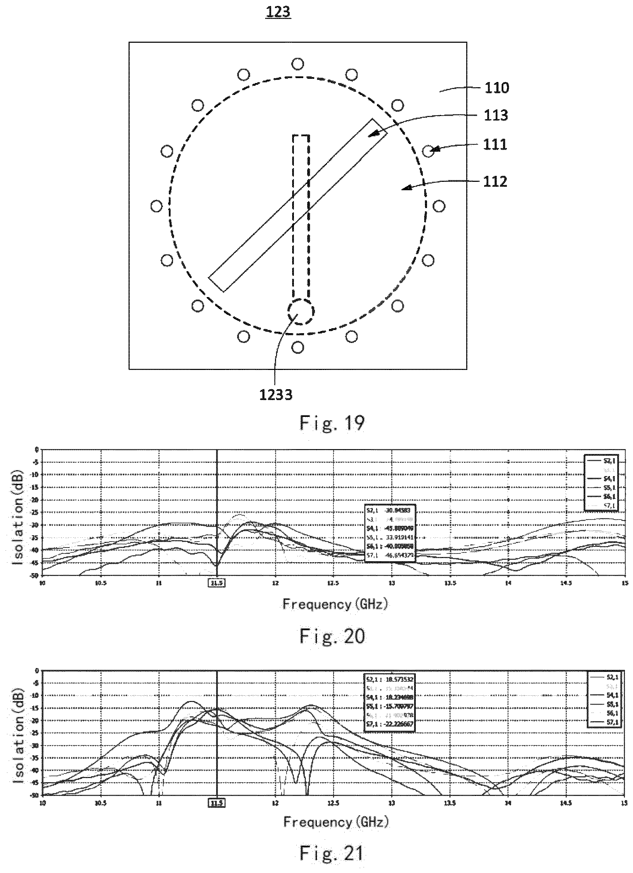

Referring to FIG. 4, FIG. 4 is a schematic diagram of anyone of the plurality of radiating units 120 of FIG. 3. Each radiating unit 120 of the plurality of radiating units 120 can be a loop antenna 121 as shown in FIG. 4. In other embodiments, the radiating unit of the plurality of radiating units 120 can be other antenna types, such as a patch antenna 122 as shown in FIG. 18, a slot antenna 123 as shown in FIG. 19, etc.

Specifically, the loop antenna 121 may be a loop patch antenna disposed on a surface of the first dielectric substrate 110. The loop antenna 121 includes a radiating part 1211, a ground part 1212, and a feed part 1213. The radiating part 1211 is substantially an annular microstrip line with an open on one end. The ground part 1212 and the feed part 1213 are both substantially straight microstrip lines. The ground part 1212 and the feed part 1213 are both disposed in a circular ring formed by the radiating part 1211. One end of the ground part 1212 is connected to one end of the opening of the radiating part 1211. The feed part 1213 is connected to the other end of the opening of the radiating part 1211. The ground part 1212 can be connected to a ground pin 114 through a plurality of corresponding via holes (not shown in the figures) on the first dielectric substrate 110 and the plurality of second dielectric substrates 130. The feed part 1213 can also be connected to the plurality of power dividers 140 through corresponding via holes (not shown in the figures) on the first dielectric substrate 110 and the plurality of second dielectric substrates 130 to receive or transmit corresponding radio frequency signals.

The first dielectric substrate 110 is provided with a plurality of ground through holes 111. The plurality of ground through holes 111 are arranged around the loop antenna 121. In this way, the plurality of ground through holes 111 pass through the first dielectric substrate 110 and the plurality of second dielectric substrates 130 to be connected to the ground, so as to form a clearance area 112. It can be understood that in a Z-axis direction of the first dielectric substrate 110, no electronic devices are provided in the clearance area 112. In this way, the loop antenna 121 is disposed in the clearance area 112, which can significantly reduce interference. Moreover, since the loop antenna 121 is disposed in the clearance area 112, after the loop antenna 121 receives the current through the feed part 1213, the current can be concentrated in the loop antenna 121, thereby reducing coupling with other loop antennas 121 and improving the isolation of each radiating unit.

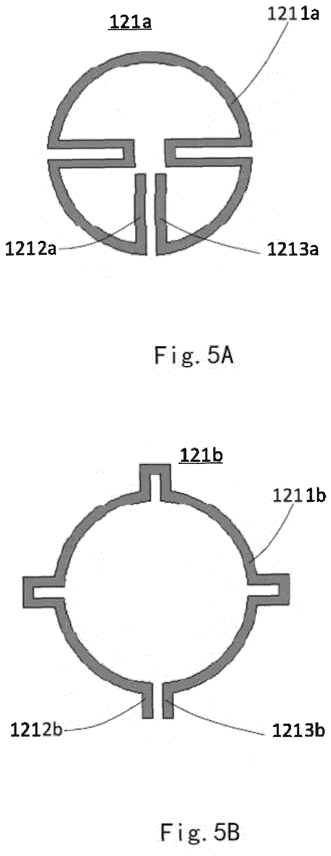

It can be understood that when each of the plurality of radiating units 120 is a loop antenna, this application does not limit the specific shape of the loop antenna. For example, please refer to FIG. 5A, in other embodiments, each of the plurality of radiating units 120 may also be a loop antenna 121a. The loop antenna 121a has substantially the same structure as the loop antenna 121, and also includes a radiating part 1211a, a ground part 1212a, and a feed part 1213a. The difference is that both sides of the radiating part 1211a of the loop antenna 121a are also recessed toward a center of the loop antenna 121a.

For example, please refer to FIG. 5B, in other embodiments, each of the plurality of radiating units 120 may also be a loop antenna 121b. The loop antenna 121b has substantially the same structure as the loop antenna 121, and also includes a radiating part 1211b, a ground part 1212b, and a feed part 1213b. The difference is that the ground part 1212b and the feed part 1213b of the loop antenna 121b are formed by extending a distance from two ends of the opening of the radiating part 1211b in a direction away from a center of the loop antenna 121b. The radiating part 1211b also protrudes outwardly.

It can be understood that this application does not limit the specific shape of the loop antenna 121. In other embodiments, the loop antenna can also have other shapes.

Referring to FIG. 1 again, the antenna array 20 to be tested includes a plurality of antenna radiating units 210. When the antenna testing device 10 is used to test and calibrate the antenna array 20, a side of the antenna testing device 10 provided with the plurality of radiating units 120 needs to face the antenna array 20, and all the detecting radiating units need to be in one-to-one correspondence with the same quantity of corresponding antenna radiating units 210 on the antenna array 20 to achieve corresponding signals transmitting and receiving between all the detecting radiating units and corresponding antenna radiating units 210 of the plurality of antenna radiating units 210. In this way, the predetermined arrangement of the plurality of radiating units 120 corresponds to the arrangement of the antenna radiating units 210 in the antenna array 20 to be tested.

Referring to FIG. 3 again, for example, in the embodiment, corresponding to the arrangement of the antenna radiating units 210 in the antenna array 20, the predetermined arrangement of the plurality of radiating units 120 includes that in every two rows of radiating units 120, each radiating unit 120 in one row is staggered between two radiating units 120 in another row, or each radiating unit 120 is staggered between two radiating units 120 in another row, so that any three radiating units 120 form a triangular arrangement. This application does not limit the predetermined arrangement of the plurality of radiating units 120, as long as the predetermined arrangement of the plurality of radiating units 120 is the same as the arrangement of the antenna radiating units 210 in the antenna array 20 to be tested. For example, in other embodiments, corresponding to the arrangement of the antenna radiating units 210 in the antenna array 20 to be tested, the predetermined arrangement may also be that the plurality of radiating units 120 are arranged in a square, circular, or diamond shape.

Referring to FIG. 2 again, the plurality of second dielectric substrates 130 are stacked on another surface of the first dielectric substrate 110 away from the plurality of radiating units 120.

Referring to FIGS. 6 and 7, FIGS. 6 and 7 are respectively schematic diagrams of a connection relationship between the plurality of power dividers 140 and the plurality of radiating units 120 from a first perspective in two embodiments of the present application. The first perspective is a viewing angle seen from a YZ plane cut through a middle of the antenna testing device 10. As shown in FIGS. 6 and 7, the plurality of power dividers 140 are disposed among the plurality of second dielectric substrates 130. In some embodiments, as shown in FIG. 6, when the plurality of second dielectric substrates 130 include a layer of second dielectric substrates 130, the plurality of power dividers 140 may be disposed on one side of the second dielectric substrate 130 closer to the first dielectric substrate 110. In some embodiments, as shown in FIG. 7, when the plurality of second dielectric substrates 130 include multiple layers of second dielectric substrates 130, the plurality of power dividers 140 may be disposed among the multiple layers of second dielectric substrates 130, such as among three layers of second dielectric substrates 130. The plurality of power dividers 140 are connected to the radiating units of the plurality of radiating units 120 located in the first region 1101. That is, the plurality of power dividers 140 are respectively connected to the feed parts of the plurality of detecting radiating units. The radiating units of the plurality of radiating units 120 located in the second area 1102 are grounded through loads 1214. That is the feed part 1213 of each grounded radiating unit is grounded through the load 1214. The load 1214 may be a resistor with a resistance of 50 ohms. And the loads 1214 can be arranged among the plurality of second dielectric substrates 130. This application does not limit the specific electronic components of the load 1214. For example, in other embodiments, the load 1214 may include at least one of a resistor, a capacitor, and an inductor.

Referring to FIG. 6, in some embodiments, the plurality of power dividers 140 are connected in parallel to the radiating units of the plurality of radiating units 120 located in the first region 1101. That is, the plurality of power dividers 140 are connected in parallel to the plurality of detecting radiating units. Specifically, the power divider 140 in this application may be a Wilkinson power divider. The power divider 140 includes a first port and two second ports. The first port is connected to a radio frequency (RF) output port 31 of the network analyzer 30 (shown in FIG. 1) to receive the corresponding RF signals, or the first port is connected to a RF input port 32 to output corresponding RF signals to the network analyzer 30. Each second port is connected to the feed part 1213 of the corresponding detecting radiating unit. For example, in this embodiment, each second port is connected to the corresponding feed part of the loop antenna 121 serving as the detecting radiating unit. The power divider 140 is used to divide the energy of the radio frequency signal input at the first port into two feed signals with equal energy, and output them through the second ports. In this way, the energy of the feed signal of each detecting radiating unit in the present application is the same. Or the power divider 140 is used to collect the signals received by the two second ports to the first port for outputting.

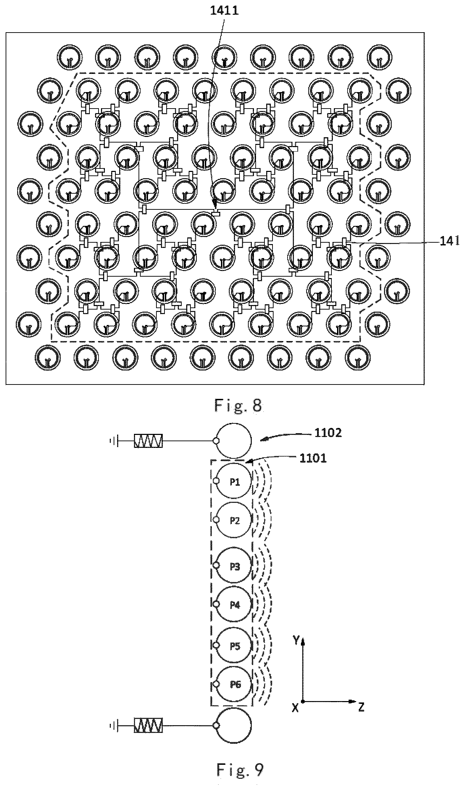

Referring to FIG. 7, in some embodiments, the plurality of power dividers 140 may also be connected in sequence to form a cascade circuit structure to feed signals with the same energy to each detecting radiating unit. Specifically, taking the cascade circuit structure shown in FIG. 7 as an example, in the first stage circuit, the first port of the power divider 140 is used to connect to the radio frequency output port, and the two second ports are respectively connected to the first ports of the other two power dividers 140. In the second stage circuit, the four second ports of the two power dividers 140 are respectively connected to the first ports of the four power dividers 140. By analogy, the quantity of power dividers 140 in the last stage circuit is half of the quantity of the detecting radiating units of the plurality of radiating units 120. For example, please refer to FIG. 8, which is a schematic diagram of a cascade circuit structure formed by connecting the plurality of power dividers 140 in an embodiment of the present application. The first ports of the power dividers 140 in the first stage circuit serves as connection ports 1411. The connection ports 1411 are used to connect the RF output ports 31 or the RF input ports 32. It can be understood that each stage of circuit in the cascade circuit structure can be respectively disposed on each of the plurality of second dielectric substrates 130. In this way, the signals received by all the detecting radiating units can be integrated to the connection port 1411 during reception, and is output to the network analyzer 30 through the RF input ports 32; the energy of the radio frequency signal output from the RF output ports 31 is evenly output to each detecting radiating unit through the connection ports 1411 during transmission.

It can be understood that in other embodiments, in addition to being the Wilkinson power divider, the power divider 140 can also be other types or a combination of other types of power dividers, as long as the energy of the radio frequency signals fed into each detecting radiating unit is finally the same, this application does not limit the type of the power divider 140.

It can be understood that when performing test and calibration of the antenna array, the two parameters of the antenna array, phase and power amplitude, are mainly tested and calibrated. In the related technology, a single induction antenna is used to test the antenna array, so there is no consistency problem in phase and power amplitude for the single induction antenna. The antenna testing device 10 provided in this application includes the plurality of detecting radiating units, if there is a phase or power amplitude deviation between the plurality of detecting radiating units, it will cause distortion when the antenna testing device 10 performs test and calibration on the antenna array 20. Therefore, the phases and power amplitude of the plurality of detecting radiating units in the antenna testing device 10 should maintain high consistency.

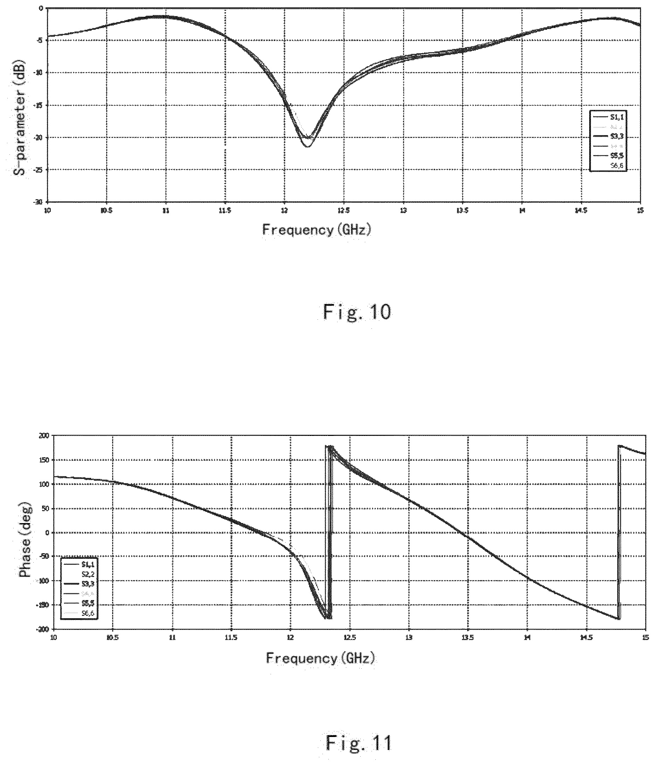

Referring to FIG. 9, in the embodiment, in order to reduce the complexity of the test data and improve the readability of the test data, only six detecting radiating units (such as a first detecting radiating unit P1 to a sixth detecting radiating unit P6) are shown in FIG. 9 and the S-parameter test data of the antenna testing device with two grounded radiating units is taken as an example to illustrate the radiation characteristics of the antenna testing device provided by this application. The two grounded radiating units shown in FIG. 9 are arranged on an upper and lower sides of the six detecting radiating units, so that each of the six detecting radiating units is arranged between two radiating units, that is, the environment of the six detecting radiating units is the same. FIGS. 10 and 11 are respectively a power amplitude diagram and a phase diagram of the S-parameters measured by the six detecting radiating units shown in FIG. 9. It can be seen from FIGS. 10 and 11 that the power amplitude and phase of the signal excited by the detecting radiating units of the antenna testing device shown in FIG. 9 have high consistency. That is to say, the return loss and output effect of each detecting radiating unit in the antenna testing device 10 provided by the present application can maintain a high consistency. In this way, the antenna testing device 10 meets the design requirements for testing and calibrating the antenna array 20.

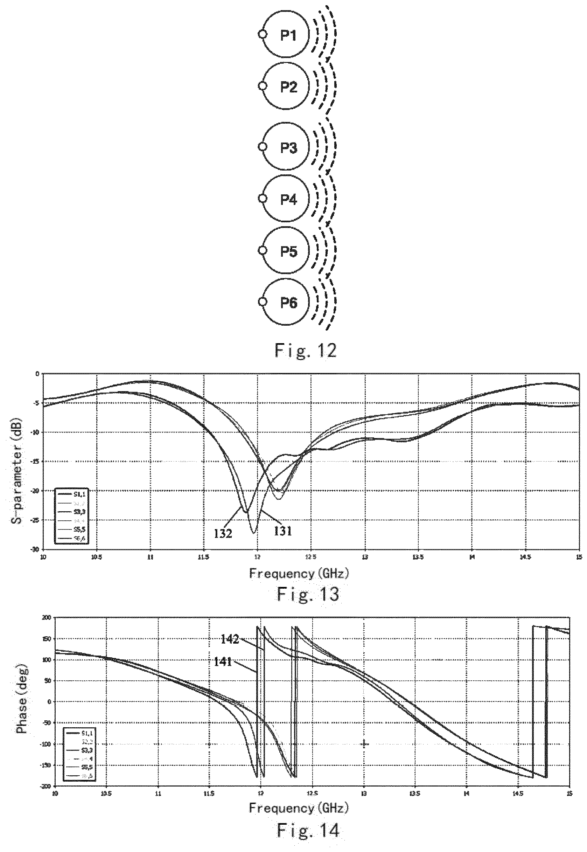

Referring to FIGS. 12 to 14, as shown in FIG. 12, the six detecting radiating units without the grounded radiating units are used for comparison. FIGS. 13 and 14 are respectively a power amplitude diagram and a phase diagram of the S-parameters measured by the six detecting radiating units shown in FIG. 12. It can be seen from FIGS. 13 and 14 that the consistency of the power amplitude and the phase of the signals excited by the detecting radiating units shown in FIGS. 13 and 14 are poor. In particular, due to changes in the surrounding environment, the first detecting radiating unit P1 and the sixth detecting radiating unit P6, which are respectively arranged on the upper and lower sides, cause the power amplitude (please refer to curve S131 and curve S132) and the phase (please refer to curve S141 and curve S142) of the S-parameters of the first detecting radiating unit P1 and the sixth detecting radiating unit P6 to deviate far from other detecting radiating units. Obviously, according to FIGS. 9 to 11, and compared with FIGS. 12 to 14, it can be seen that the antenna testing device 10 provided with the grounded radiating units and the detecting radiating units has higher consistency of the power amplitude and phase of the signals, which is more suitable for testing the antenna array 20. This also shows that the antenna testing device 10 provided by the present application can effectively improve the consistency of the power amplitude and phase of the signals of the detecting radiating units in the first area 1101 through the radiating units arranged in the second area 1102.

Referring to FIG. 1, it can be understood that when the antenna testing device 10 is testing the antenna array 20, the detecting radiating unit in the antenna testing device 10 needs to correspond one-to-one with the antenna radiating units 210 in the antenna array 20 for signal transmission and reception, so as to better obtain the data of the corresponding antenna radiating units 210 in the corresponding antenna array 20, so as to calibrate the corresponding test. That is to say, each detecting radiating unit in the antenna testing device 10 and the corresponding antenna radiating units 210 should have higher coupling, adjacent detecting radiating units should have higher isolation. In this way, the antenna testing device 10 can reduce the transmission or reception characteristics of each antenna radiating unit 210 in the corresponding antenna array 20 due to the interference caused by the mutual coupling between the radiating units in the antenna testing device 10, thereby improving the accuracy of the testing and calibrating.

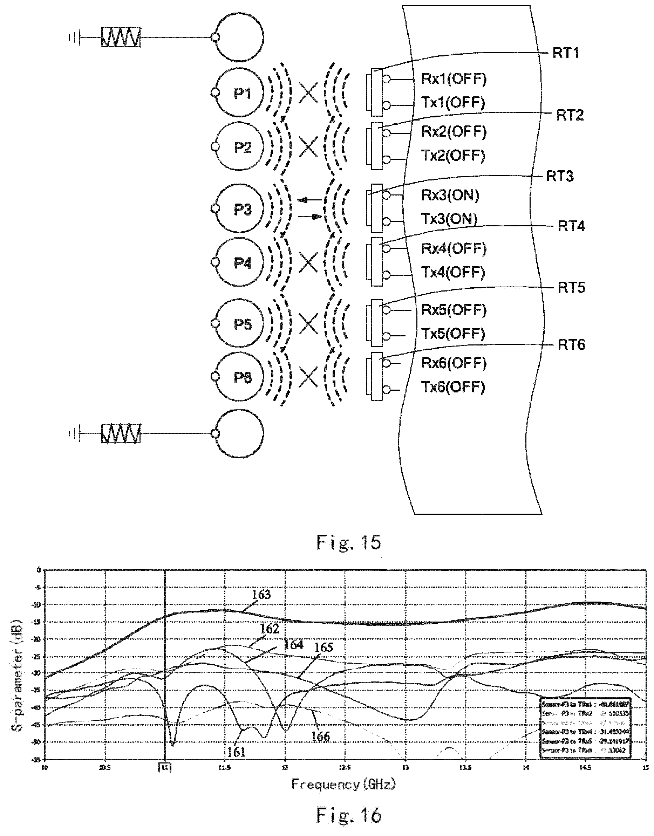

Referring to FIGS. 15 and 16, FIG. 15 is a schematic diagram of signal transmission and reception between the third detecting radiating unit P3 in the antenna testing device shown in FIG. 9 and the antenna RT1 to the antenna RT6 in the antenna array. FIG. 16 is a graph of the transmission coefficient between the third detecting radiating unit P3 and the antenna RT1 to the antenna RT6. Curve S161 is the transmission coefficient curve between the third detecting radiating unit P3 and the antenna RT1. Curve S162 is the transmission coefficient curve between the third detecting radiating unit P3 and the antenna RT2. Curve S163 is the transmission coefficient curve between the third detecting radiating unit P3 and the antenna RT3. Curve S164 is the transmission coefficient curve between the third detecting radiating unit P3 and the antenna RT4. Curve S165 is the transmission coefficient curve between the third detecting radiating unit P3 and the antenna RT5. Curve S166 is the transmission coefficient curve between the third detecting radiating unit P3 and the antenna RT6. As can be seen from FIG. 15, the transmission coefficient between the third detecting radiating unit P3 and the antenna RT3 is relatively higher, and the transmission coefficient between the third detecting radiating unit P3 and each of the antenna RT1, the antenna RT2, the antenna RT4, the antenna RT5 and the antenna RT6 are relatively lower. And in the Ku band of the low orbit satellite (LEO), a difference in transmission coefficient between the third detecting radiating unit P3 and the antenna RT3 is more than 15 dB compared with the transmission coefficient between the third detecting radiating unit P3 and other antennas. This shows that each detecting radiating unit in the antenna testing device 10 provided by the present application has better independence, and the coupling between each detecting radiating unit and the corresponding antenna is better, which is suitable for the design requirements for testing antennas array 20.

Referring to FIGS. 3 and 17, FIG. 17 shows an isolation curve diagram between the seventh detecting radiating unit P7 and the other six detecting radiating units (the eighth detecting radiating unit P8 to the thirteenth detecting radiating unit P13) on the first dielectric substrate 110 in FIG. 3. Curve S171 is an isolation curve between the seventh detecting radiating unit P7 and the eighth detecting radiating unit P8. Curve S172 is an isolation curve between the seventh detecting radiating unit P7 and the nineth detecting radiating unit P9. Curve S173 is an isolation curve between the seventh detecting radiating unit P7 and the tenth detecting radiating unit P10. Curve S174 is an isolation curve between the seventh detecting radiating unit P7 and the eleventh detecting radiating unit P11. Curve S175 is an isolation curve between the seventh detecting radiating unit P7 and the twelfth detecting radiating unit P12. Curve S176 is an isolation curve between the seventh detecting radiating unit P7 and the thirteenth detecting radiating unit P13. Curve S176 is an isolation curve between the seventh detecting radiating unit P7 and the fourteenth detecting radiating unit P14. It can be understood that the isolation index represents the level of mutual influence between the detecting radiating units. It can be seen from FIG. 17 that the isolation between the seventh detecting radiating unit P7 and each of the eighth detecting radiating unit P8 to the thirteenth detecting radiating unit P13 are all below -22 dB. This shows that in the antenna testing device 10 provided by the present application, each detecting radiating unit has a lower level of mutual influence and a high isolation, and can meet the design requirements for multi-antenna test and calibration.

It can be understood that in other embodiments, the plurality of radiating units 120 may also include other types of antennas, such as the patch antenna 122 shown in FIG. 18, the slot antenna 123 shown in FIG. 19, etc.

Referring to FIGS. 18 and 19, when the radiating unit on the first dielectric substrate 110 is a patch antenna 122 or a slot antenna 123, a ground through hole 111 is defined in the first dielectric substrate 110 to form a clearance area 112. And the patch antenna 122 and the slot antenna 123 are both disposed in the clearance area 112.

Specifically, the patch antenna 122 includes a substantially circular conductive patch 1221. And the conductive patch 1221 is provided with a feed point 1223.

The slot antenna 123 includes a slot hole 113 and a feed part 1233. The slot hole 113 is defined in the clearance area 112 of the first dielectric substrate 110. Projections of the feed portion 1233 and the slot hole 113 in the Z-axis direction at least partially overlap. In this way, after receiving the feed signals, the feed part 1233 can couple the feed signal to the slot hole 113.

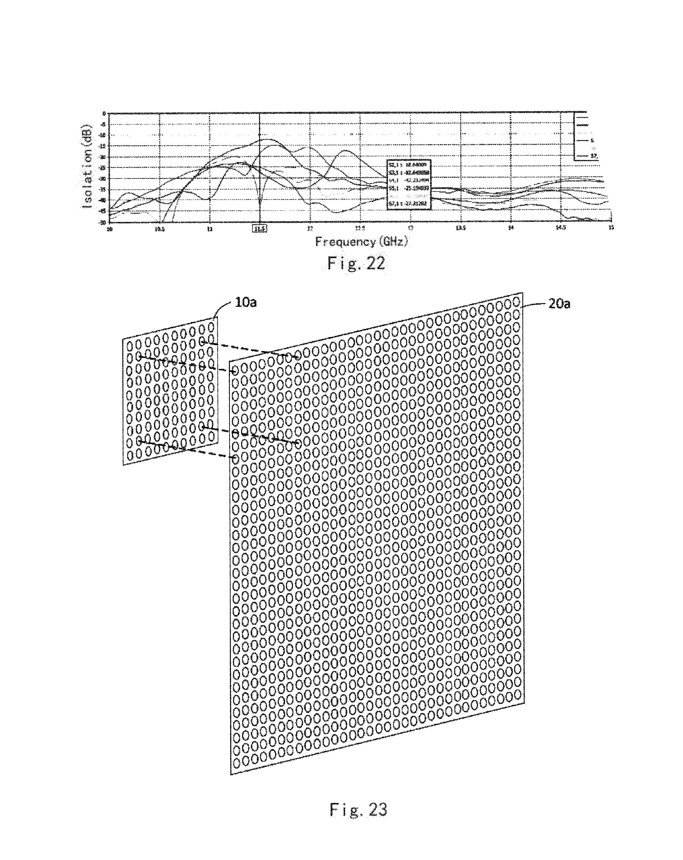

Referring to FIGS. 20 to 22, FIG. 20 shows a schematic diagram of the isolation curves between the loop antenna 121 located in a central position and other loop antennas measured when the seven loop antennas 121 are arranged according to the arrangement of the seventh detecting radiating unit P7 to the thirteenth detecting radiating unit P13 in FIG. 3. FIG. 21 shows a schematic diagram of the isolation curves between the patch antenna 122 located in a central position and other patch antennas measured when the seven patch antennas 122 are arranged according to the arrangement of the seventh detecting radiating unit P7 to the thirteenth detecting radiating unit P13 in FIG. 3. FIG. 22 shows a schematic diagram of the isolation curves between the slot antenna 123 located in a central position and other slot antennas measured when the seven slot antennas 123 are arranged according to the arrangement of the seventh detecting radiating unit P7 to the thirteenth detecting radiating unit P13 in FIG. 3. As can be seen from FIGS. 20 to 22, the isolation between the loop antenna 121 located in the central position and other loop antennas 121 are all less than - 25 dB, and the isolation between the patch antenna 122 located in the central position and other patch antennas 122 are all less than -12 dB, and the isolation between the slot antenna 123 located in the central position and other slot antennas 123 are all less than -14 dB.

In summary, the antenna testing device 10 provided by the present application includes the first dielectric substrate 110, the plurality of radiating units 120, the plurality of second dielectric substrates 130, and the plurality of power dividers 140. The surface of the first dielectric substrate 110 includes the first area 1101 and the second area 1102, and the second area 1102 surrounds the first area 1101. The plurality of radiating units 120 are arranged in an array in a predetermined arrangement in the first area 1101 and the second area 1102. In this way, the radiating units of the plurality of radiating units 120 are arranged in the first area 1101 are in the same environment. The plurality of power dividers 140 are connected to the plurality of radiating units 120 arranged in the first area 1101 to provide feed signals. In this way, the signal amplitude and signal phase excited by the radiating units 120 arranged in the first area 1101 have a high consistency, meeting the design requirements of multiple antenna testing devices, and can perform test and calibration to the plurality of antenna radiating units 210 in the antenna array 20 at the same time to improve test and calibration efficiency. Furthermore, the plurality of second dielectric substrates 130 are stacked on the side of the first dielectric substrate 110 away from the plurality of radiating units 120, and the plurality of power dividers 140 are arranged among the plurality of second dielectric substrates 130, which can reduce the area of the antenna testing device 10.

Referring to FIG. 1 again, the network analyzer 30 of the antenna testing system includes the RF output port 31 and the RF input port 32. This application does not limit the quantity of the RF output port 31 and the RF input port 32 of the network analyzer 30. The antenna array 20 includes a signal port 220. It can be understood that when performing signal transmission test and calibration on the antenna array 20, the RF output port 31 is connected to the signal port 220 of the antenna array 20, and the RF input port 32 is connected to the input ports of the plurality of power dividers 140 (or the connection port 1411 of the first stage circuit in the cascade circuit structure formed by the plurality of power dividers 140). In this way, after the antenna radiating units 210 in the antenna array 20 receives the electrical signal fed by the network analyzer 30, the antenna radiating units 210 can transmit the signal to the outside and receive by the plurality of radiating units 120 located in the first area 1101. After the plurality of radiating units 120 located in the first area 1101 receive the signal, the plurality of radiating units 120 output the return signal to the network analyzer 30 through the plurality of power dividers and the RF input ports, and the network analyzer 30 analyzes the return signal to obtain the transmission data of the antenna array 20.

When performing signal reception test and calibration on the antenna array 20, the RF output port 31 is connected to the input ports of the plurality of power dividers 140 (or the connection ports 1411 of the first stage circuit in the cascade circuit structure formed by the plurality of power dividers 140), the RF input port 32 is connected to the signal port 220 of the antenna array 20. In this way, after the radiating units of the plurality of radiating units 120 located in the first area 1101 receive the electrical signal fed by the network analyzer 30, the radiating units 120 can transmit the signal to the outside and receive by the plurality of antenna radiating units 210 in the antenna array 20. After the plurality of antenna radiating units 210 in the antenna array 20 receive the signal, the plurality of antenna radiating units 210 output the return signal to the network analyzer 30 through the signal port 220, and the network analyzer 30 analyzes the return signal to obtain the reception data of the antenna array 20.

The antenna testing system 100 further includes a first slide rail 41, a second slide rail 42, a drive unit, and a processor (not shown in the figures). The drive unit is connected to the antenna testing device 10. The drive unit 43 is used to move according to control instructions outputted by the processor, thereby driving the antenna testing device 10 to move on the first slide rail 41 or the second slide rail 42. The first slide rail 41 and the second slide rail 42 can be perpendicular to each other, the first slide rail 41 can be a horizontal axis slide rail, and the second slide rail 42 can be a vertical axis slide rail. It can be understood that a plurality of positioning holes can also be defined on the first dielectric substrate 110 and the antenna array 20. In this way, the antenna testing device 10 is driven to move, so that the positioning holes on the first dielectric substrate 110 are aligned with the corresponding positioning holes on the antenna array 20, so that the radiating unit located in the first area 1101 of the plurality of radiating units 120 in the antenna testing device 10 can be aligned with the same quantity of antenna radiating units 210 in the antenna array 20 for testing.

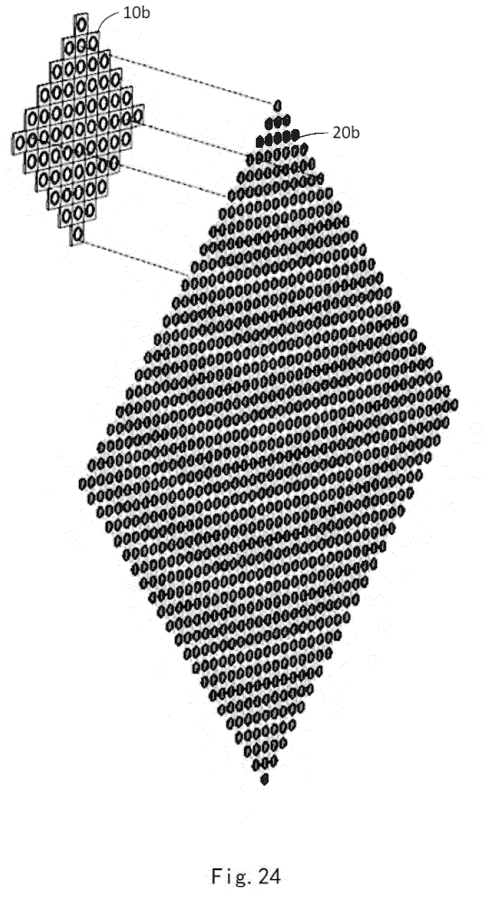

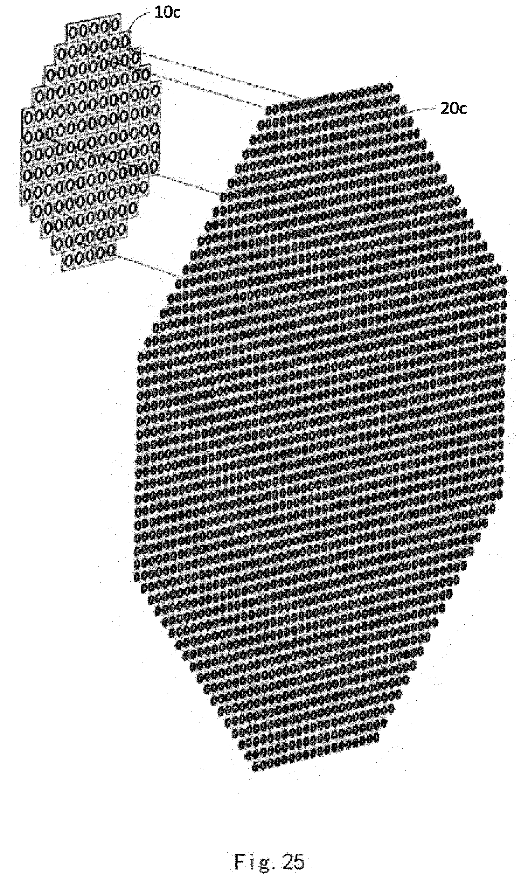

It can be understood that corresponding to different antenna arrangements in the antenna array, the arrangement of the radiating units of the plurality of radiating units 120 located in the first area 1101 is also different. For example, please refer to FIGS. 23 to 25, when the arrangement of the antennas in the antenna array 20a is square, the corresponding radiating units of the plurality of radiating units located in the first area of the corresponding antenna testing device 10a are also arranged in a square. When the arrangement of the antennas in the antenna array 20b is diamond, the corresponding radiating units of the plurality of radiating units located in the first area of the corresponding antenna testing device 10b are also arranged in a diamond. When the arrangement of the antennas in the antenna array 20c is octagonal, the corresponding radiating units of the plurality of radiating units located in the first area of the corresponding antenna testing device 10c are also arranged in an octagon.

The embodiments shown and described above are only examples. Even though numerous characteristics and advantages of the present technology have been set forth in the foregoing description, together with details of the structure and function of the present disclosure, the disclosure is illustrative only, and changes may be made in the detail, including in matters of shape, size and arrangement of the parts within the principles of the present disclosure, up to and including the full extent established by the broad general meaning of the terms used in the claims.

## Claims

1. An antenna testing device (10) configured to test an antenna array (20), the antenna testing device (10) comprising:
a first dielectric substrate (110), a surface of the first dielectric substrate (110) comprising a first area (1101) and a second area (1102), the second area (1102) surrounding the first area (1101);
a plurality of radiating units (120) arranged in an array in a predetermined arrangement in the first area (1101) and the second area (1102), the predetermined arrangement of the plurality of radiating units (120) corresponding to an arrangement of a plurality of antenna radiating units (120) of the antenna array (20);
a plurality of second dielectric substrates (130) stacked on another surface of the first dielectric substrate (110) away from the plurality of the radiating units (120); and
a plurality of power dividers (140) arranged among the plurality of second dielectric substrates (130), the plurality of power dividers (140) connected to the plurality of radiating units (120) arranged in the first area (1101).

2. The antenna testing device (10) of claim 1, wherein a part of the plurality of radiating units (120) are located in the first area (1101), and another part of the plurality of radiating units (120) are located in the second area (1102), the plurality of radiating units (120) located in the first area (1101) are configured to transmit signals or receive signals, and a part of the plurality of radiating units (120) located in the second area (1102) are grounded.

3. The antenna testing device (10) of claim 1, wherein the plurality of radiating units (120) comprise loop antennas (121).

4. The antenna testing device (10) of claim 1, wherein the predetermined arrangement comprises each radiating unit (120) of the plurality of radiating units (120) is staggered between two radiating units (120) in another row and in a triangular arrangement.

5. The antenna testing device (10) of claim 1, wherein the plurality of radiating units (120) located in the second area (1102) are grounded through loads (1214), the loads (1214) are arranged among the plurality of second dielectric substrates (130).

6. The antenna testing device (10) of claim 5, wherein each of the loads (1214) is a resistor with a resistance of 50 ohms.

7. The antenna testing device (10) of claim 1, wherein the plurality of power dividers (140) are connected in sequence to form a cascade circuit structure to feed signals with a same energy to each of the plurality of detecting radiating unit (120) arranged in the first area (1101).

8. The antenna testing device (10) of claim 1, wherein the plurality of radiating units (120) comprise loop antennas (121), the first dielectric substrate (110) is provided with a plurality of ground through holes (111), each of the loop antennas (121) is surrounded by a corresponding ground through hole (111), the plurality of ground through holes (111) pass through the first dielectric substrate (110) and the plurality of second dielectric substrates (130) to be connected to a ground to form a clearance area (112), the loop antennas (121) are arranged in the clearance area (112).

9. The antenna testing device (10) of claim 1, wherein each of the plurality of power dividers (140) comprises a first port and two second ports, each of the plurality of power dividers (140) is configured to divide a signal received through the first port into two signals with a same energy and respectively output the two feed signals through the two second ports; or
each of the plurality of power dividers (140) is configured to combine two signals respectively received through the two second ports into one signal and output the signal through the first port.

10. An antenna testing system (100) configured to test an antenna array (20), the antenna testing system (100) comprising the antenna testing device (10) according to any of claims 1 to 9.

11. The antenna testing system (100) of claim 10, further comprising a network analyzer (30), wherein the network analyzer (30) comprises a RF output port (31) and a RF input port (32), the RF output port (31) is connected to the plurality of power dividers (140), the RF input port (32) is connected to a signal port of the antenna array (20); or
the RF output port (31) is connected to the signal port of the antenna array (20), the RF input port (32) is connected to the plurality of power dividers (140).

12. The antenna testing system (100) of claim 10, wherein the plurality of antenna radiating units (120) of the antenna array (20) are arranged in a square, the plurality of radiating units (120) located in the first area (1101) are also arranged in the square;
or the plurality of antenna radiating units (120) of the antenna array (20) are arranged in a diamond, the plurality of radiating units (120) located in the first area (1101) are also arranged in the diamond;
or the plurality of antenna radiating units (120) of the antenna array (20) are arranged in an octagon, the plurality of radiating units (120) located in the first area (1101) are also arranged in the octagon.
